(19) Europäisches Patentamt / European Patent Office / Office européen des brevets

(11) **EP 3 691 253 B1**

(12) **EUROPEAN PATENT SPECIFICATION**

(45) Date of publication and mention
of the grant of the patent:
**15.11.2023 Bulletin 2023/46**

(21) Application number: **19382068.5**

(22) Date of filing: **31.01.2019**

(51) International Patent Classification (IPC):
**H01L 31/108** (2006.01)  **H01L 31/113** (2006.01)
**H01L 27/13** (2006.01)  **H04N 25/75** (2023.01)
**H04N 25/76** (2023.01)

(52) Cooperative Patent Classification (CPC):
**H01L 31/108; H01L 27/13; H01L 31/1136;
H04N 25/75; H04N 25/76;** G01R 27/2605

(54) **CHARGE SENSING DEVICE WITH READOUT OF SIGNAL BY DETECTING A CHANGE OF CAPACITANCE OF COMBINED GATE AND QUANTUM CAPACITANCE COMPARED TO A REFERENCE CAPACITANCEA**

LADUNGSDETEKTIERUNGSVORRICHTUNG DIE AUSGELESEN WIRD DURCH DETEKTION EINER ÄNDERUNG DER KOMBINATION VON GATE- UND QUANTENKAPAZITÄT IN VERGLEICH ZU EINER REFERENZKAPAZITÄT

DISPOSITIF DE DÉTECTION DE CHARGE AVEC LECTURE PAR DÉTECTION D'UNE CHANGE DE CAPACITÉ ENTRE LA COMBINAISON DE LA CAPACITÉ DE GRILLE ET LA CAPACITÉ QUANTIQUE ET UNE CAPACITÉ DE RÉFÉRENCE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**05.08.2020 Bulletin 2020/32**

(73) Proprietors:
• **Fundació Institut de Ciències Fotòniques
08860 Castelldefels (ES)**
• **Institució Catalana de Recerca I Estudis Avançats
08010 Barcelona (ES)**

(72) Inventors:
• **GOOSSENS, Stijn
08860 Castelldefels (ES)**
• **KOPPENS, Frank
08860 Castelldefels (ES)**
• **KONSTANTATOS, Gerasimos
08860 Castelldefels (ES)**

(74) Representative: **Ponti & Partners, S.L.P
Edifici PRISMA
Av. Diagonal núm. 611-613, Planta 2
08028 Barcelona (ES)**

US-A1- 2014 111 652   US-A1- 2014 267 880
US-A1- 2016 141 835   US-A1- 2017 082 566
US-A1- 2018 197 956   US-B2- 10 070 082

• DHARMENDAR REDDY ET AL: "TOPICAL REVIEW;Graphene field-effect transistors;Topical Review", JOURNAL OF PHYSICS D: APPLIED PHYSICS, INSTITUTE OF PHYSICS PUBLISHING LTD, GB, vol. 44, no. 31, 14 July 2011 (2011-07-14) , page 313001, XP020208144, ISSN: 0022-3727, DOI: 10.1088/0022-3727/44/31/313001
• FOXE M ET AL: "Detection of ionizing radiation using graphene field effect transistors", 2009 IEEE NUCLEAR SCIENCE SYMPOSIUM AND MEDICAL IMAGING CONFERENCE (NSS/MIC 2009), ORLANDO, FL, USA, IEEE, PISCATAWAY, NJ, USA, 24 October 2009 (2009-10-24), pages 90-95, XP031826487, ISBN: 978-1-4244-3961-4
• Gerasimos Konstantatos ET AL: "Hybrid graphene-quantum dot phototransistors with ultrahigh gain", Nature Nanotechnology, vol. 7, no. 6, 1 January 2012 (2012-01-01) , pages 363-368, XP055039980, ISSN: 1748-3387, DOI: 10.1038/nnano.2012.60

(56) References cited:
**EP-A1- 3 429 190        US-A1- 2008 122 453**

EP 3 691 253 B1

- **EBRISH M A ET AL: "Dielectric thickness dependence of quantum capacitance in graphene varactors with local metal back gates", DEVICE RESEARCH CONFERENCE (DRC), 2012 70TH ANNUAL, IEEE, 18 June 2012 (2012-06-18), pages 105-106, XP032214889, DOI: 10.1109/DRC.2012.6256974 ISBN: 978-1-4673-1163-2**

**Description**

FIELD OF THE INVENTION

The present invention relates, in a first aspect, to an electronic apparatus, comprising an electronic device comprising a capacitor that is used for charge sensing purposes and shows quantum capacitance, and a read-out circuit providing an improved read-out.

A second aspect of the present invention relates to a system comprising the electronic apparatus of the first aspect of the invention.

BACKGROUND OF THE INVENTION

Electronic apparatuses which comprise the features of the preamble clause of claim 1 of the present invention are known in the art, i.e. comprising:

- an electronic device comprising:

  - a gate electrode structure;
  - a dielectric structure arranged over said gate electrode structure; and
  - a charge sensing structure comprising at least one 2-dimensional charge sensing layer configured to sense electrical charges and/or electrical charge density changes induced by an external physical quantity, and that is configured and arranged over said dielectric structure to provide a gate capacitance $C_g$ between the charge sensing structure and the gate electrode structure. Such an electronic device is known from EP3429190 A1.

US10070082 B2 discloses a capacitive charge sensor.

Quantum capacitance is disclosed, for example, in M. A. Ebrish et al, "Dielectric thickness dependence of quantum capacitance in graphene varactors with local metal back gates", 70th Device Research Conference, 18-20 June 2012.

The read-out circuits of the electronic apparatuses of the prior art are clearly improvable. Therefore, it is necessary to provide an alternative to the state of the art, by providing an electronic apparatuses including an improved read-out circuit which provides an improved reading of the read-out signal.

The following prior art references do not disclose devices for sensing a change in capacitance based on the quantum capacitance effect of a 2-dimensional charge sensing layer that can be tuned by a gate electrode, but are identified and described herein as representative of the state of the art.

EP3429190A1 discloses an apparatus and method for a resistive (transconductance based) read-out of a graphene based detector, particularly for a noise reduction method. That method involves applying a voltage bias to the graphene and flowing a current laterally through the graphene channel. The output signal in EP3429190A1 is the change in the current flowing through the graphene channel.

US2017082566A1 discloses a varactor and a read-out circuit based on a LC oscillator.

Gerasimos Konstantatos et al. "Hybrid graphene-quantum dot phototransistors with ultrahigh gain", Nature Nanotechnology, Vol. 7, pages 363-368 (2012) discloses a detector that can sense electrical charges and electrical charge density changes. Indeed, if that detector is illuminated with a high irradiance, the light induces charges in the QD layer that can be modelled as a change in charge carrier density. If the layer is illuminated with a single photon source, one can only speak of electrical charges and not of a change in charge carrier density.

Dharmendar Reddy et al., "Topical Review; Graphene field-effect transistors; Topical review"; Journal of Physics D: Applied Physics, Institute of Physics Publishing LTD, GB, Vol, 44, No. 31, 14 July 2011, page 313001, discloses graphene field effect transistors and also refers to the quantum capacitance effect, but does not disclose the use of the quantum capacitance for sensing purposes.

Foxe M. et al, "Detection of ionizing radiation using graphene field effect transistors", 2009 IEEE Nuclear Science Symposium and Medical Imaging Conference (NSS/MIC 2009), 24 October 2009, pages 90-95, reports a charge detector based on ionizing radiation. Figure 12 reports the effect of the ionizing radiation on the GFET transfer curve. The detection mechanism is a change in conductance as can be seen from the difference between the curves before and after exposure. The graphene sensor disclosed in Foxe et al. is also based on the read-out of a resistance change of the graphene. This is the same read-out mechanism as disclosed in EP3429190A1.

US2014111652 discloses an IR sensitization layer that serves to convert IR light to visible light photons that are later to be converted to charge by a conventional photodiode. This charge is later accumulated on a conventional capacitor.

US2018197956 discloses an image sensor based on graphene quantum dots that act as light absorber and where the output signal is a photocurrent.

SUMMARY OF THE INVENTION

To that end, the present invention relates, in a first aspect, to an electronic apparatus, comprising:

- a gate electrode structure;
- a dielectric structure arranged over said gate electrode structure; and
- a charge sensing structure comprising at least one 2-dimensional charge sensing layer configured to sense electrical charges and/or electrical charge density changes induced by an external physical quantity, and that is configured and arranged over said dielectric structure to provide a gate capacitance $C_g$ between the charge sensing structure and the gate electrode structure; wherein said charge sensing structure shows a quantum capacitance $C_q$ in series with said gate capacitance $C_g$ resulting in a total capacitance $C_{tot}$ between the charge sensing structure and the gate electrode structure;

- a read-out circuit electrically connected to the charge sensing structure or to the gate electrode structure, to detect an output voltage $V_o$ that is representative of said sensed electrical charges stored in said total capacitance $C_{tot}$ and provide a read-out signal $S_o$ based on the detected output voltage.

In contrast to the electronic apparatuses of the prior art, in the one of the first aspect of the present invention the read-out circuit comprises:

- an amplifier with a first input electrically connected to the charge sensing structure or to the gate electrode structure, to detect the output voltage and provide, at an output of the amplifier, said read-out signal; and
- a reference capacitor $C_{ref}$ that has a magnitude equal to or differing at maximum a 50% with respect to said total capacitance $C_{tot}$ when there is no induced electrical charge or electrical charge carrier density on the charge sensing structure, wherein said reference capacitor $C_{ref}$ has a first plate electrically connected to said first input of the amplifier;

and in that the electronic apparatus further comprises a first input terminal electrically connected to the one of said gate electrode structure and said charge sensing structure which is not electrically connected to the first input of the amplifier;
wherein said first input terminal is accessible to apply thereto a control voltage which is selected such that the fermi level of the charge sensing structure is tuned to the most sensitive point (i.e. around the charge neutrality point (cnp) when the 2-dimensional material is graphene);
so that when said total capacitance $C_{tot}$ changes due to a change in the quantum capacitance $C_q$ caused by an electrical charge or electrical charge carrier density induced on the charge sensing structure, an imbalance between the total capacitance $C_{tot}$ and the reference capacitance $C_{ref}$ results in a change on the output voltage $V_o$ on the first input of the amplifier that is amplified to provide the read-out signal $S_o$.

In a second aspect, the present invention relates to a system comprising the electronic apparatus of the first aspect of the invention, wherein the read-out circuit comprises means configured and arranged to select and apply said control voltage to the one of said gate electrode structure and said charge sensing structure which is not electrically connected to the first input of the amplifier.

For an embodiment, the read-out circuit further comprises a first offset correction mechanism comprising said means which are configured and arranged to select and apply a first reference voltage to a second plate of the reference capacitor $C_{ref}$, so that the output voltage on the first input of the amplifier is zero when there is no induced electrical charge or electrical charge carrier density on the charge sensing structure.

For an embodiment, said means comprises at least one voltage source that generates said control voltage To implement said embodiment, the output of the voltage source is electrically connected to the gate electrode structure or charge sensing structure, either directly or through a switch, to apply the control voltage thereto, and, preferably to the second plate of the reference capacitor $C_{ref}$, whether directly or through a switch, to apply the control voltage thereto.

For a preferred embodiment, the above mentioned means comprises a control unit configured and arranged to select and apply at least the control voltage.

In an embodiment, the control unit is configured to select the properties of the control voltage, at least regarding its magnitude.

According to a further embodiment, the said read-out circuit further comprises a second offset correction mechanism comprising the above mentioned means which are configured and arranged to select and apply to a second input of the amplifier a second reference voltage with a magnitude equal or substantially equal to the output voltage when the charge sensitivity structure is set to its most sensitivity point and there is no electrical charge or electrical charge carrier density induced by the external physical quantity.

In an embodiment, the read-out circuitry includes a reset circuit to discharge the total capacitance $C_{tot}$, preferably under the control of the control unit.

The gate electrode structure together with the dielectric and charge sensing structures arranged there over, is arranged, in a non-claimed embodiment, on a substrate.

According to non-claimed embodiment of the system of the second aspect of the present invention, the control unit further comprises an adjustment input connected to an output of the read-out circuit, and is configured to implement a closed-loop adjustment process to adjust the control voltage and/or the first and/or second reference voltage based on a read-out signal received through that adjustment input, and preferably also based on reference or set-point values with which the detected read-out signal(s) are compared.

According to some embodiments, the electronic device of the electronic apparatus of the system of the second aspect of the present invention further comprises a sensitizing sttucture or functionalizing structure arranged over the charge sensing structure, wherein the sensitizing structure or functionalizing structure is configured to induce the electrical charge carriers and/or modify the charge carrier density therein induced by said external physical quantity. Generally the sensitizing structure or functionalizing structure is only sensitive to said external physical quantity.

For an embodiment, the reference capacitor $C_{ref}$ is a separate component, with respect to the electronic device, while for an alternative embodiment, the reference capacitor $C_{ref}$ is implemented by the electronic device, with its first plate constituted by the charge sensing structure, a dielectric structure constituted by the sensitizing structure or functionalizing structure, and its second plate constituted by a top electrode structure arranged over the sensitizing structure or functionalizing structure.

According to an embodiment, electronic device and at least part of the read-out circuitry (for example an input transistor of the amplifier) are CMOS-implemented.

For an embodiment, said sensitizing structure or functionalizing structure is a photoactive structure configured and arranged to, upon illumination, generate electron-hole pairs which, due to a field created by either a Schottky junction between the charge sensing structure and the photoactive structure or a topgate electrode on top of the photoactive structure or an interlayer between the charge sensing structure and the photoactive structure, are separated and either the electrons or holes gets transported, as said induced electrical charge carriers, to the charge sensing structure, so that the optoelectronic apparatus constitutes a photodetector or an image sensor.

For an implementation of that embodiment, the system of the second aspect of the present invention implements an image sensor comprising an array of pixels, wherein the electronic apparatus comprises a plurality of the above mentioned electronic devices each constituting one pixel of said array of pixels.

According to a non-claimed embodiment, the electronic device is absent of any sensitizing or functionalizing structure arranged over the charge sensing structure, the charge sensing structure being configured to undergo a change in the electrical charge carriers and/or modify the charge carrier density therein induced by the external physical quantity.

The present invention is generally applied to sensing devices that rely sensing a change in the electrical charge carriers and/or in the charge carrier density in the charge sensing structure induced by said external physical quantity, whether directly on an exposed charge sensing structure, through the intermediation of a sensitizing layer (such as a photo-sensitizing layer, for example made up of PbS colloidal quantum dots, where light can induce the charge carriers in the charge sensing structure, or a linker biomolecule grafted on the charge sensing structure) or through the functionalization of the charge sensing structure (e.g. for biosensing).

A charge sensing structure suitable for use in the electronic device of the electronic apparatus of the system of the second aspect of present invention comprises one or more 2-dimensional charge sensing layers made of, for example, one or more of the following materials: single or few layer graphene (pure graphene, modified graphene, or functionalized graphene), black phosphorus, $MoS_2$, $WS_2$, $WSe_2$, etc.

Different physical quantities or analytes can be sensed by the electronic apparatus of the system of the second aspect of the invention, as long as they induce electrical charge carriers in the charge sensing structure and/or a change in the charge carrier density therein, such as light, gas molecules or sensing neuronal signals. The analyte of interest transfers charge to the charge sensing structure or induces an electric field that modifies the charge carrier density thereof.

Another application is for direct sensing of in vivo electrical signals, or for implementing biosensors using chemically bonded linker molecules that enhance the selectivity for specific bio-molecules. When the molecule of interest binds to the linker, it transfer charge to the charge sensing structure or induces an electric field therein that modifies its charge carrier density.

BRIEF DESCRIPTION OF THE FIGURES

In the following some preferred embodiments of the invention will be described with reference to the enclosed figures. They are provided only for illustration purposes without however limiting the scope of the invention.

Figure 1 schematically shows the system of the second aspect of the present invention, for a first embodiment;
Figure 2 schematically shows the system of the second aspect of the present invention, for a second embodiment;
Figure 3 schematically shows a Si-CMOS implementation of the electronic device and part of the readout-circuitry of the electronic apparatus of the system of the second aspect of the present invention, for the arrangement of the second embodiment;
Figure 4 schematically shows the system of the second aspect of the present invention, for a third embodiment;
Figure 5 is a schematic side view of the structure of the electronic device of the electronic apparatus of the first aspect of the invention and of the electronic apparatus of the system of the second aspect, for an embodiment, with electrical connections indicated as round circles: CE = charge sensing layer electrode and BE = bottom electrode.
Figure 6 is a schematic side view of the of the electronic device of the electronic apparatus of the first aspect of the invention and of the electronic apparatus of the system, for an embodiment for which the electronic device comprises a photoactive structure for, upon illumination, generate electron-hole pairs which are separated and one of them gets transported to the charge sensing structure (CE), as indicated by the charge flow illustrated.

DESCRIPTION OF THE PREFERRED EMBODIMENTS

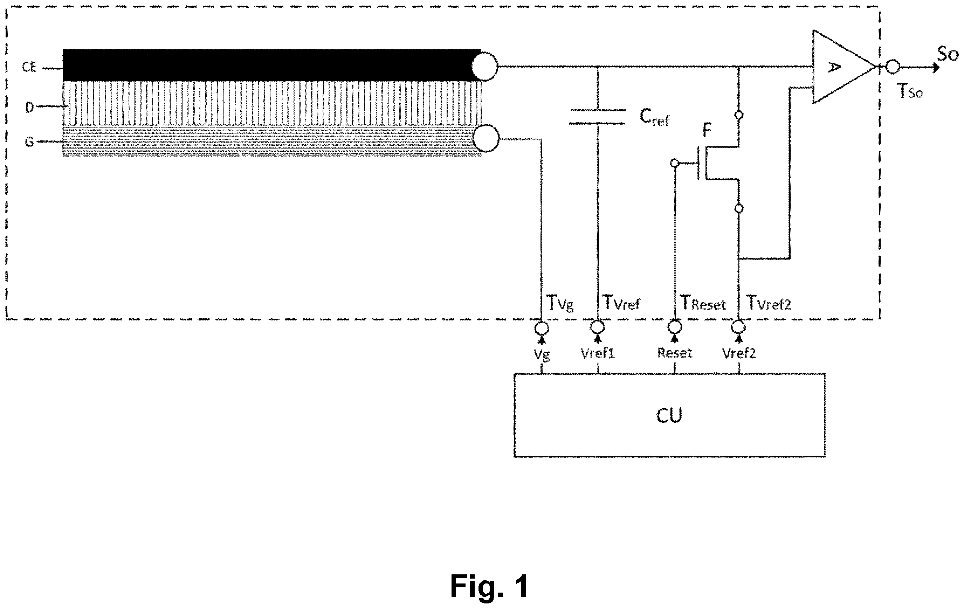

Figures 1, 2, and 4 show respective first, second and third embodiments of the system of the present invention, for which the electronic apparatus thereof comprises:

- an electronic device forming a capacitive sensing device (CSD), comprising:

  - a gate electrode structure G;
  - a dielectric structure D arranged over the gate electrode structure G; and
  - a charge sensing structure CE comprising at least one 2-dimensional charge sensing layer configured to sense electrical charges and/or electrical charge density changes induced by an external physical quantity, and that is configured and arranged over said dielectric structure D to provide a gate capacitance $C_g$ between the charge sensing structure CE and the gate electrode structure G; wherein said charge sensing structure CE shows a quantum capacitance $C_q$ in series with said gate capacitance $C_g$ resulting in a total capacitance $C_{tot}$ between the charge sensing structure CE and the gate electrode structure G;

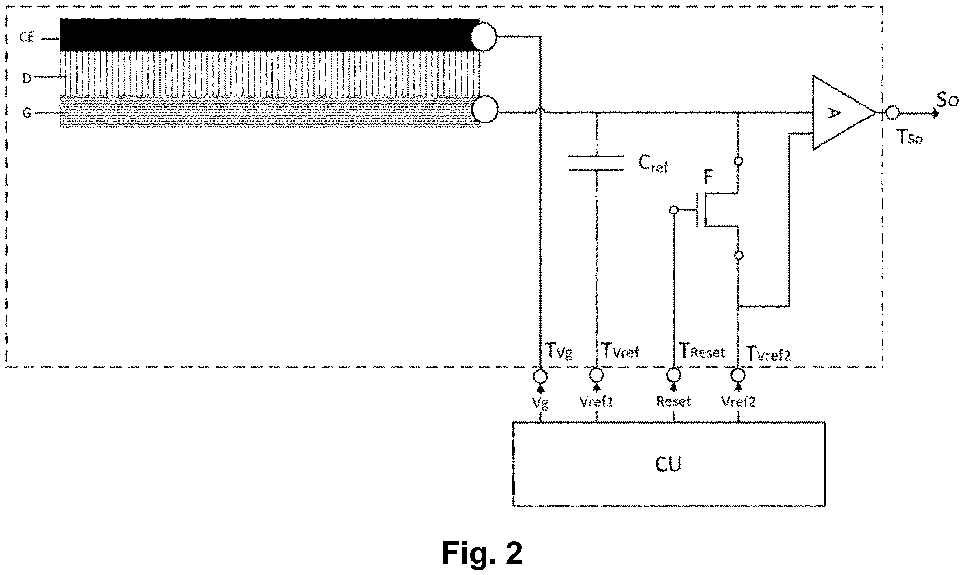

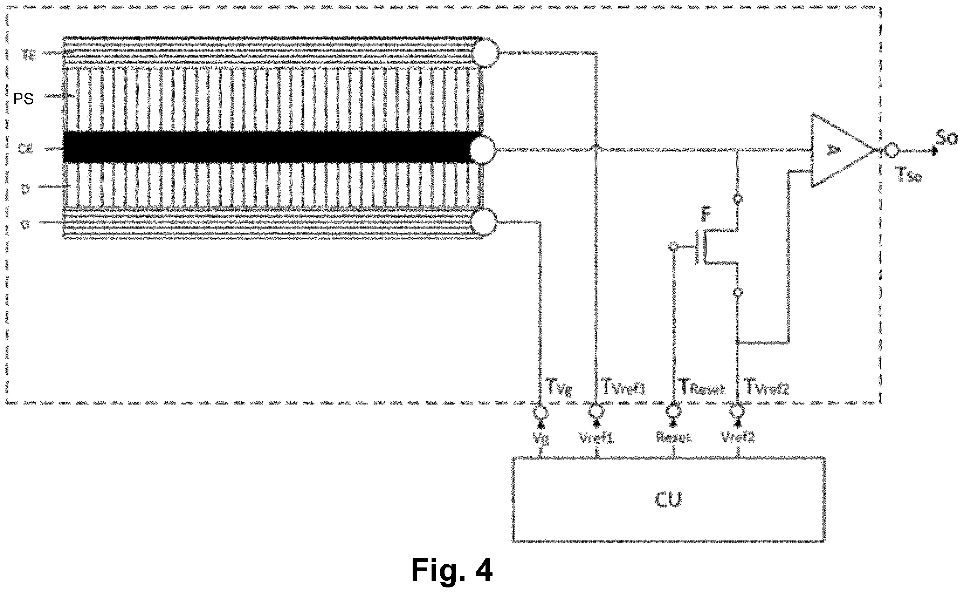

- a read-out circuit electrically connected to the charge sensing structure CE (for Figures 1 and 4) or to the gate electrode structure G (for Figure 2), to detect an output voltage $V_o$ that is representative of the sensed electrical charges stored in the total capacitance $C_{tot}$ and provide a read-out signal $S_o$ based on the detected output voltage $V_o$.

As shown in those figures, the read-out circuit comprises:

- an amplifier A with a first input electrically connected to the charge sensing structure CE (for Figures 1 and 4) or to the gate electrode structure G (for Figure 2) to detect the output voltage $V_o$ and provide, at an output of the amplifier A, the read-out signal $S_o$;
- a reference capacitor $C_{ref}$ that has a magnitude equal to or differing at maximum a 50% with respect to said total capacitance $C_{tot}$ when there is no induced electrical charge or electrical charge carrier density on the charge sensing structure CE, wherein the reference capacitor $C_{ref}$ has a first plate electrically connected to the first input of the amplifier A; and

- means comprising a control unit CU configured and arranged to select and apply a control voltage $V_g$ to the one of the gate electrode structure G (for Figures 1 and 4) and the charge sensing structure CE (for Figure 2) which is not electrically connected to the first input of the amplifier A; wherein the control voltage $V_g$ is selected such that the fermi level of the charge sensing structure CE is tuned to the most sensitive point,

so that when said total capacitance $C_{tot}$ changes due to a change in the quantum capacitance $C_q$ caused by an electrical charge or electrical charge carrier density induced on the charge sensing structure CE, an imbalance between the total capacitance $C_{tot}$ and the reference capacitance $C_{ref}$ results in a change on the output voltage $V_o$ on the first input of the amplifier A that is amplified to provide the read-out signal $S_o$.

As shown Figures 1, 2 and 4, the read-out circuit further comprises a first offset correction mechanism comprising the control unit CU which is configured and arranged to select and apply a first reference voltage $V_{ref1}$ to a second plate of the reference capacitor $C_{ref}$, so that the output voltage $V_o$ on the first input of the amplifier A is zero when there is no induced electrical charge or electrical charge carrier density on the charge sensing structure CE.

Also, for the embodiments illustrated in Figures 1, 2 and 4, the read-out circuit further comprises a second offset correction mechanism comprising the control unit CU which is configured and arranged to select and apply to a second input of the amplifier A a second reference voltage $V_{ref2}$ with a magnitude equal or substantially equal to the output voltage $V_o$ when the charge sensitivity structure CE is set to its most sensitive point and there is no electrical charge or electrical charge carrier density induced by the external physical quantity.

As shown in Figures 1, 2 and 4, the read-out circuit comprises a reset circuit, formed by a transistor F, to discharge the total capacitance $C_{tot}$ under the control of the control unit CU (by closing the transistor F so as to connect CE or G to $V_{ref2}$), when the illustrated Reset signal is applied thereto.

The classical capacitance of the CSD is given by the following formula:

$$C_g = \varepsilon_r \varepsilon_0 A / d$$

Where $\varepsilon_r$ is the relative permittivity of the dielectric material, $\varepsilon_0$ is the vacuum permittivity, A the area of the capacitor and d the thickness of the dielectric material.

For 2-dimensional materials there is another capacitance that needs to be taken into account due to their finite density of states. This is the quantum capacitance $C_q$. $C_q$ is in series with the classical capacitance and thus reduces the total capacitance $C_{tot}$ of the system

(1/$C_{tot}$=1/$C_g$+1/$C_q$). The quantum capacitance is in general a function of the fermi level in the system, so it can be tuned by an external electric field, or a charge induced in the system by an external physical quantity.

When the 2-dimensional material is graphene, the quantum capacitance per unit area $C_q$/A is described as follows:

$$C_Q = \frac{2e^2}{\hbar\, v_F \sqrt{\pi}} \left( |n_G| + |n^*| \right)^{1/2}$$

Where e is the electron charge, h the planck constant, $v_F$ the Fermi velocity of graphene, $n_G$ the induced carrier density in the graphene and n* the residual impurity density.

When $C_{tot}$ changes due to the charge or charge carrier density induced on the charge sensing electrode, an imbalance in the capacitor system results in a voltage change $V_o$ on the input of the amplifier A.

$$V_o = C_{tot}/(C_{ref} + C_{tot})^*(V_g - V_{ref1}) + V_{ref1}$$

Amplifier A then amplifies the output voltage $V_o$ to output signal So.

In case the sensing electrode is made up of (few layer) graphene, this is at the charge neutrality point or dirac point. The output voltage $V_o$ of the structure is measured by the amplifier A with respect to $V_{ref2}$. $V_{ref2}$ needs to be set such that it is equal (or substantially equal) to the output voltage $V_o$ when the charge sensing electrode CE is set to its most sensitive point and there is no charge or charge carrier density induced by the external physical quantity.

For the third embodiment, i.e. that illustrated in Figure 4, the electronic device further comprises a sensitizing or functionalizing structure PS arranged over the charge sensing structure CE, wherein said sensitizing or functionalizing structure PS is configured to induce said electrical charges and/or modify the electrical charge carrier density therein induced by said external physical quantity, wherein the sensitizing or functionalizing structure PS is only sensitive to said external physical quantity.

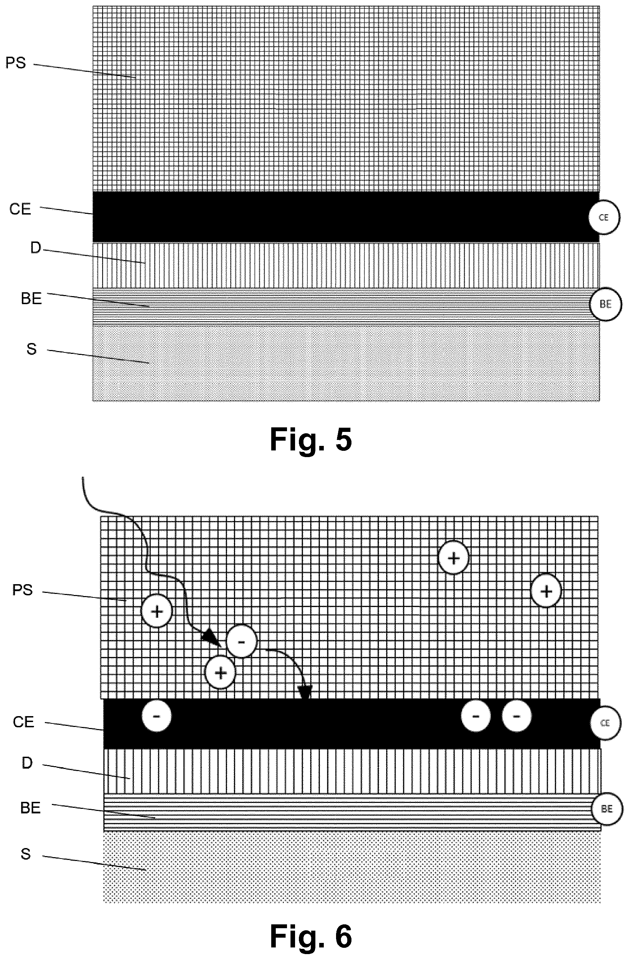

The stacked up structure of the electronic device of said third embodiment is shown in Figures 5 and 6, for an implementation for which the electronic device is a photodetector which comprises a substrate S, a bottom electrode structure BE (as the above mentioned gate electrode structure), and a sensitizing or functionalizing structure PS constituted by a photoactive structure PS (formed by colloidal quantum dots, III-V semiconductor, perovskites, 2D material, etc.) arranged over the charge sensing structure CE (for example, formed by a single layer or few layer graphene, black phosphorus, MoS2, WS2, WSe2 etc.) configured and arranged to, upon illumination, generate electron-hole pairs which, due to a built-in field created by a Schottky junction between the charge sensing structure CE and the photoactive structure PS, are separated and either the electrons or holes (depending on the type of Schottky junction) gets transported to the charge sensing structure CE. A voltage now builds up on the gate capacitor $C_g$. In case of a photosensitive layer it is the total photogenerated charge: $Q_{Ph}$=EQE*$q_e$*$\tau_{tr}$ A/$E_p$ I, (EQE is the external quantum efficiency, $q_e$ the electron charge, $\tau_{tr}$ the trapping time of the photogenerated charges and I the irradiance, A the area of the device and $E_p$ the photon energy). This process is illustrated in Figure 6.

Also for the third embodiment, as shown in Figure 4, the reference capacitor $C_{ref}$ is implemented by the electronic device, with its first plate constituted by the charge sensing structure CE, a dielectric structure constituted by the sensitizing or functionalizing structure PS, and its second plate constituted by a top electrode structure TE arranged over the sensitizing or functionalizing structure PS.

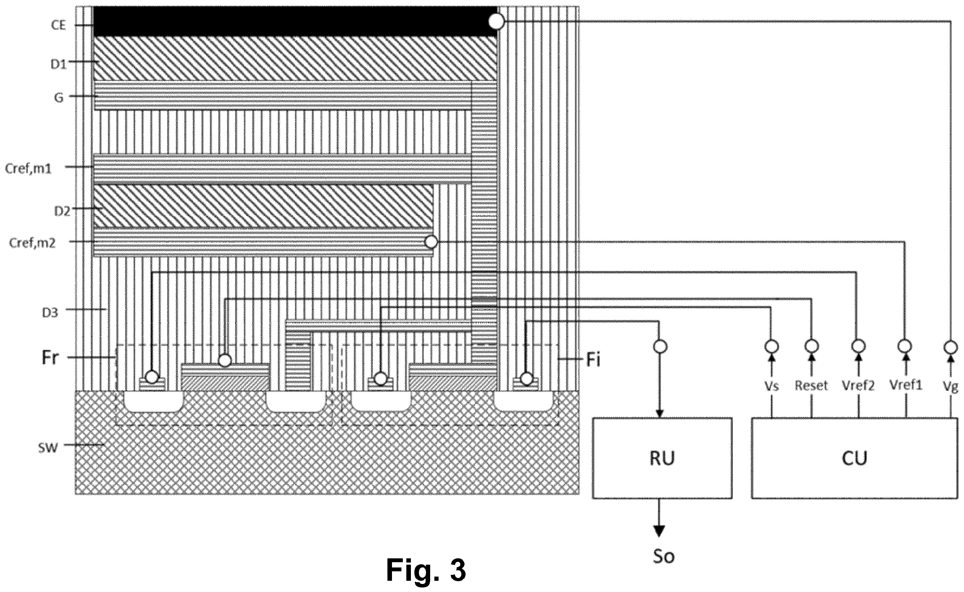

The layout of the second embodiment, illustrated in Figure 2, can have advantages for integration in complementary metal oxide semiconductor devices. Hence, Figure 3 shows a possible CMOS implementation of the electronic device and part of the readout-circuit (particularly, an input transistor Fi of the amplifier A) of the electronic apparatus of the system of the second aspect of the present invention, for the arrangement of the second embodiment. The rest of the read-out circuit is depicted by means of block RU.

In Figure 3 is shown how on a silicon wafer (SW) field effect transistors Fr (the reset transistor F) and Fi (the input transistor of the amplifier A) are implemented. In a layer above, the reference capacitor $C_{ref}$ is implemented with two metal layers, namely $C_{ref,m1}$ and $C_{ref,m2}$, and a dielectric layer (D2). Above the reference capacitor $C_{ref}$ the capacitive sensing device (CSD) is implemented. $C_{ref,m1}$, G and the gate electrode of Fi are connected via a vertical metal connection. The structures are embedded in a dielectric D3. A control unit CU provides the necessary signals described in embodiment 1 and moreover provides Vs to bias transistor Fi in the proper way. The drain of transistor Fi is connected to read-out unit RU that further amplifies and processes the signal to provide finally output signal $S_o$ that is proportional to the electrical charge or charge carrier density on CE induced by the external physical quantity.

Figures 1, 2 and 4 also show respective embodiments of the electronic apparatus of the first aspect of the present invention which comprises the components depicted within or in contact with the contour of the dotted-line squares (which can be embedded in an integrated circuit), i.e. the components of the electronic apparatus of the system of the second aspect of the present invention and further input pin terminals $TV_g$, $T_{vref1}$, $T_{Reset}$ and $T_{Vref1}$, and also an output pin connected to terminal $TS_o$, so that a control unit CU can be connected to those input pin terminals to provide voltages $V_g$, $V_{ref1}$, $V_{ref2}$ and Reset signal, while $S_o$ goes

out through output terminal $TS_o$. For some embodiments, the control unit CU is also integrated in the integrated circuit.

A person skilled in the art could introduce changes and modifications in the embodiments described without departing from the scope of the invention as it is defined in the attached claims.

**Claims**

1. An electronic apparatus, comprising:

   - an electronic device comprising:

     - a gate electrode structure (G, BE);
     - a dielectric structure (D) arranged over said gate electrode structure (G, BE); and
     - a charge sensing structure (CE) comprising at least one 2-dimensional charge sensing layer configured to sense electrical charges and/or electrical charge density changes induced by an external physical quantity, and that is configured and arranged over said dielectric structure (D) to provide a gate capacitance ($C_g$) between the charge sensing structure (CE) and the gate electrode structure (G, BE); **characterized in that** said charge sensing structure (CE) shows a quantum capacitance ($C_q$) in series with said gate capacitance ($C_g$) resulting in a total capacitance ($C_{tot}$) between the charge sensing structure (CE) and the gate electrode structure (G, BE);

     - a read-out circuit electrically connected to the charge sensing structure (CE) or to the gate electrode structure (G), to detect an output voltage ($V_o$) that is representative of said sensed electrical charges stored in said total capacitance ($C_{tot}$) and provide a read-out signal ($S_o$) based on the detected output voltage ($V_o$);

     wherein said read-out circuit comprises:

     - an amplifier (A) with a first input electrically connected to the charge sensing structure (CE) or to the gate electrode structure (G), to detect said output voltage ($V_o$) and provide, at an output of the amplifier (A), said read-out signal ($S_o$); and
     - a reference capacitor ($C_{ref}$) that has a magnitude equal to or differing at maximum a 50% with respect to said total capacitance ($C_{tot}$) when there is no induced electrical charge or electrical charge carrier density on the charge sensing structure (CE), wherein said reference capacitor ($C_{ref}$) has a first plate electrically connected to said first input of the amplifier (A);
   and **in that** the electronic apparatus further comprises a first input terminal ($TV_g$) electrically connected to the one of said gate electrode structure (G) and said charge sensing structure (CE) which is not electrically connected to the first input of the amplifier (A);
   wherein said first input terminal ($TV_g$) is accessible to apply thereto a control voltage ($V_g$) which is selected such that the fermi level of the charge sensing structure (CE) is tuned to the most sensitive point;
   so that when said total capacitance ($C_{tot}$) changes due to a change in the quantum capacitance ($C_q$) caused by an electrical charge or electrical charge carrier density induced on the charge sensing structure (CE), an imbalance between the total capacitance ($C_{tot}$) and the reference capacitance ($C_{ref}$) results in a change on the output voltage ($V_o$) on the first input of the amplifier (A) that is amplified to provide the read-out signal ($S_o$).

2. A system comprising an electronic apparatus, wherein the electronic apparatus is defined according to claim 1, and wherein said read-out circuit further comprises means configured and arranged to select and apply said control voltage ($V_g$) to the one of said gate electrode structure (G) and said charge sensing structure (CE) which is not electrically connected to the first input of the amplifier (A).

3. The system of claim 2, wherein the read-out circuit further comprises a first offset correction mechanism comprising said means, which are configured and arranged to select and apply a first reference voltage ($V_{ref1}$) to a second plate of the reference capacitor ($C_{ref}$), so that the output voltage ($V_o$) on the first input of the amplifier (A) is zero when there is no induced electrical charge or electrical charge carrier density on the charge sensing structure (CE).

4. The system of claim 2 or 3, wherein said means comprises a voltage source that generates said control voltage ($V_g$).

5. The system of claim 2, 3 or 4, wherein said means comprises a control unit (CU) configured and arranged to select and apply said control voltage ($V_g$).

6. The system of claim 5, wherein the control unit (CU) is configured to select the properties of said control voltage ($V_g$), at least regarding its magnitude.

7. The system of any of claims 2 to 6, wherein said read-out circuit further comprises a second offset correction mechanism comprising said means which are configured and arranged to select and apply to a second input of the amplifier (A) a second reference voltage ($V_{ref2}$) with a magnitude equal or substantially equal to the output voltage ($V_o$) when the charge sensitivity structure (CE) is set to its most sensitivity point and there is no electrical charge or electrical charge carrier density induced by the external physical quantity.

8. The system of claim 7 when depending on claim 5, wherein said control unit (CU) is also configured and arranged to select and apply said second reference voltage ($V_{ref2}$).

9. The system of any of claims 2 to 8, wherein said read-out circuitry further comprises a reset circuit to discharge the total capacitance ($C_{tot}$).

10. The system according to any of claims 2 to 9, wherein the electronic device further comprises a sensitizing structure (PS) or a functionalizing structure (PS) arranged over said charge sensing structure (CE), wherein said sensitizing structure (PS) or functionalizing structure (PS) is configured to induce said electrical charges and/or modify the electrical charge carrier density therein induced by said external physical quantity, wherein the sensitizing structure (PS) or functionalizing structure (PS) is only sensitive to said external physical quantity.

11. The system of any of claims 2 to 10, wherein said reference capacitor ($C_{ref}$) is a separate component, with respect to the electronic device.

12. The system of claim 10, wherein said reference capacitor ($C_{ref}$) is implemented by the electronic device, with said first plate constituted by said charge sensing structure (CE), a dielectric structure constituted by said sensitizing structure (PS) or said functionalizing structure (PS), and said second plate constituted by a top electrode structure (TE) arranged over said sensitizing structure (PS) or said functionalizing structure (PS).

13. The system of any of claims 2 to 12, wherein the electronic device and at least part of the read-out circuitry are CMOS-implemented.

14. The system of claim 10 or 12, wherein said sensitizing structure (PS) or said functionalizing structure (PS) is a photoactive structure configured and arranged to, upon illumination, generate electron-hole pairs which, due to a field created by either a Schottky junction between the charge sensing structure (CE) and the photoactive structure (PS) or a top electrode structure (TE) on top of the photoactive structure (PS), are separated and either the electrons or holes gets transported, as said induced electrical charge carriers, to the charge sensing structure (CE).

15. The system according to claim 14, implementing an image sensor comprising an array of pixels, wherein the electronic apparatus comprises a plurality of said electronic devices each constituting one pixel of said array of pixels.

**Patentansprüche**

1. Elektronisches Gerät, umfassend:

- eine elektronische Vorrichtung, umfassend:

- eine Gate-Elektroden-Struktur (G, BE);
- eine dielektrische Struktur (D) die über der Gate-Elektroden-Struktur (G, BE) angeordnet ist, und
- eine Ladungserfassungsstruktur (CE), die zumindest eine 2-dimensionale Ladungserfassungsschicht umfasst, die dafür konfiguriert ist, elektrische Ladungen und/oder elektrische Ladungsdichteänderungen, die durch eine äußere physikalische Größe induziert werden, zu erfassen, und die dafür konfiguriert und über der dielektrischen Struktur (D) angeordnet ist, um zwischen der Ladungserfassungsstruktur (CE) und der Gate-Elektroden-Struktur (G, BE) eine Gate-Kapazität ($C_g$) bereitzustellen;

**dadurch gekennzeichnet, dass** die Ladungserfassungsstruktur (CE) eine Quantenkapazität ($C_q$) in Reihe mit der Gate-Kapazität ($C_g$) zeigt, die in einer Gesamtkapazität ($C_{tot}$) zwischen der Ladungserfassungsstruktur (CE) und der Gate-Elektroden-Struktur (G, BE) resultiert;
- eine Ausleseschaltung, die mit der Ladungserfassungsstruktur (CE) oder mit der Gate-Elektroden-Struktur (G) elektrisch verbunden ist, um eine Ausgangsspannung ($V_o$) zu detektieren, die repräsentativ für die in der Gesamtkapazität ($C_{tot}$) gespeicherten erfassten elektrischen Ladungen ist, und auf der Grundlage der detektierten Ausgangsspannung ($V_o$) ein Auslesesignal ($S_o$) bereitzustellen;

wobei die Ausleseschaltung umfasst:

- einen Verstärker (A) mit einem ersten Eingang, der mit der Ladungserfassungsstruktur (CE) oder mit der Gate-Elektroden-Struktur (G) elektrisch verbunden ist, um die Ausgangsspannung (Vo) zu detektieren und an einem Ausgang des Verstärkers (A) das Auslesesignal (So) bereitzustellen; und
- einen Referenzkondensator (Cref), der eine Größe aufweist, die gleich der Gesamtkapazität (Ctot) ist oder sich in Bezug auf sie um maximal 50 % unterscheidet, wenn es auf der Ladungserfassungsstruktur (CE) keine induzierte elektrische Ladung oder elektrische Ladungsträgerdichte gibt, wobei der Referenzkondensator ($C_{ref}$) eine erste Platte aufweist, die mit dem ersten Eingang des Verstärkers (A) elektrisch verbunden ist,

und dadurch, dass das elektronische Gerät ferner einen ersten Eingangsanschluss (TVg), der mit der Gate-Elektroden-Struktur (G) oder mit der Ladungserfassungsstruktur (CE), die nicht mit dem ersten Eingang des Verstärkers (A) elektrisch verbunden ist, elektrisch verbunden ist, umfasst,

wobei der erste Eingangsanschluss (TVg) zugänglich ist, um daran eine Steuerspannung (Vg) anzulegen, die so gewählt wird, dass das Fermi-Niveau der Ladungserfassungsstruktur (CE) auf den empfindlichsten Punkt abgestimmt wird,

so dass, wenn sich die Gesamtkapazität (Ctot) aufgrund einer Änderung der Quantenkapazität (Cq), die durch eine auf der Ladungserfassungsstruktur (CE) induzierte elektrische Ladung oder elektrische Ladungsträgerdichte verursacht wird, ändert, ein Ungleichgewicht zwischen der Gesamtkapazität (Ctot) und der Referenzkapazität (Cref) zu einer Änderung der Ausgangsspannung (Vo) an dem ersten Eingang des Verstärkers (A) führt, die verstärkt wird, um das Auslesesignal (So) bereitzustellen.

2. System umfassend ein elektronisches Gerät, wobei das elektronische Gerät ein elektronisches Gerät gemäß Anspruch 1 definiert ist und wobei die Ausleseschaltung ferner Mittel umfasst, die dafür konfiguriert und angeordnet sind, die Steuerspannung ($V_g$) auszuwählen und an diejenige der Gate-Elektroden-Struktur (G) oder der Ladungserfassungsstruktur (CE), die nicht mit dem ersten Eingang des Verstärkers (A) elektrisch verbunden ist, anzulegen.

3. System nach Anspruch 2, wobei die Ausleseschaltung ferner einen ersten Offset-Korrekturmechanismus umfasst, der die Mittel umfasst, die dafür konfiguriert und angeordnet sind, eine erste Referenzspannung ($V_{ref1}$) auszuwählen und an eine zweite Platte des Referenzkondensators ($C_{ref}$) anzulegen, so dass die Ausgangsspannung ($V_o$) an dem ersten Eingang des Verstärkers (A) null ist, wenn es an der Ladungserfassungsstruktur (CE) keine induzierte elektrische Ladung oder elektrische Ladungsträgerdichte gibt.

4. System nach Anspruch 2 oder 3, wobei das Mittel eine Spannungsquelle umfasst, die die Steuerspannung ($V_g$) erzeugt.

5. System nach Anspruch 2, 3 oder 4, wobei das Mittel eine Steuereinheit (CU) umfasst, die dafür konfiguriert und angeordnet ist, die Steuerspannung ($V_g$) auszuwählen und anzulegen.

6. System nach Anspruch 5, wobei die Steuereinheit (CU) dafür konfiguriert ist, die Eigenschaften der Steuerspannung ($V_g$) zumindest hinsichtlich ihrer Größe auszuwählen.

7. System nach einem der Ansprüche 2 bis 6, wobei die Ausleseschaltung ferner einen zweiten Offset-Korrekturmechanismus umfasst, der die Mittel umfasst, die dafür konfiguriert und angeordnet sind, eine zweite Referenzspannung ($V_{ref2}$) mit einer Größe gleich oder im Wesentlichen gleich der Ausgangsspannung ($V_o$) auszuwählen und an einen zweiten Eingang des Verstärkers (A) anzulegen, wenn die Ladungserfassungsstruktur (CE) auf ihren empfindlichsten Punkt eingestellt ist und wenn es keine durch die äußere physikalische Größe induzierte elektrische Ladung oder elektrische Ladungsträgerdichte gibt.

8. System nach Anspruch 7, wenn abhängig von Anspruch 5, wobei die Steuereinheit (CU) auch dafür konfiguriert und angeordnet ist, die zweite Referenzspannung ($V_{ref2}$) auszuwählen und anzulegen.

9. System nach einem der Ansprüche 2 bis 8, wobei die Ausleseschaltung ferner eine Rücksetzschaltung zum Entladen der Gesamtkapazität ($C_{tot}$) umfasst.

10. System nach einem der Ansprüche 2 bis 9, wobei die elektronische Vorrichtung ferner eine Sensibilisierungsstruktur (PS) oder eine Funktionalisierungsstruktur (PS) umfasst, die über der Ladungserfassungsstruktur (CE) angeordnet ist, wobei die Sensibilisierungsstruktur (PS) oder Funktionalisierungsstruktur (PS) dafür konfiguriert ist, die elektrischen Ladungen zu induzieren und/oder die darin durch die äußere physikalische Größe induzierte elektrische Ladungsträgerdichte zu ändern, wobei die Sensibilisierungsstruktur (PS) oder Funktionalisierungsstruktur (PS) nur für die äußere physikalische Größe empfindlich ist.

11. System nach einem der Ansprüche 2 bis 10, wobei der Referenzkondensator ($C_{ref}$) in Bezug auf die elektronische Vorrichtung eine separate Komponente ist.

12. System nach Anspruch 10, wobei der Referenzkondensator ($C_{ref}$) durch die elektronische Vorrichtung implementiert ist, wobei die erste Platte durch die Ladungserfassungsstruktur (CE) gebildet ist, wobei eine dielektrische Struktur durch die Sensibilisierungsstruktur (PS) oder durch die Funktionalisierungsstruktur (PS) gebildet ist und wobei die zweite Platte durch eine obere Elektrodenstruktur (TE), die über der Sensibilisierungsstruktur (PS) oder der Funktionalisierungsstruktur (PS) angeordnet ist, gebildet ist.

13. System nach einem der Ansprüche 2 bis 12, wobei die elektronische Vorrichtung und zumindest ein Teil der Ausleseschaltung in CMOS implementiert sind.

14. System nach Anspruch 10 oder 12, wobei die Sensibilisierungsstruktur (PS) oder Funktionalisierungsstruktur (PS) eine fotoaktive Struktur ist, die dafür konfiguriert und angeordnet ist, bei Beleuchtung Elektron-Loch-Paare zu erzeugen, die aufgrund eines Felds, das entweder durch einen Schottky-Übergang zwischen der Ladungserfassungsstruktur (CE) und der fotoaktiven Struktur (PS) oder einer oberen Elektrodenstruktur (TE) auf der fotoaktiven Struktur (PS) erzeugt wird, getrennt werden und entweder die Elektronen oder die Löcher als die induzierten elektrischen Ladungsträger zu der Ladungserfassungsstruktur (CE) transportiert werden.

15. System nach Anspruch 14, das einen Bildsensor implementiert, der eine Pixelanordnung umfasst, wobei das elektronische Gerät eine Vielzahl der elektronischen Vorrichtungen umfasst, die jeweils ein Pixel der Pixelanordnung bilden.

**Revendications**

1. Appareil électronique, comprenant :

    - un dispositif électronique comprenant :

        - une structure d'électrode de grille (G, BE) ;
        - une structure diélectrique (D) agencée sur ladite structure d'électrode de grille (G, BE) ; et
        - une structure de détection de charge (CE) comprenant au moins une couche de détection de charge bidimensionnelle configurée pour détecter les charges électriques et/ou les changements de densité de charge électrique induits par une quantité physique externe, et qui est configurée et agencée sur ladite structure diélectrique (D) pour fournir une capacité de grille ($C_g$) entre la structure de détection de charge (CE) et la structure d'électrode de grille (G, BE) ; **caractérisé en ce que** ladite structure de détection de charge (CE) présente une capacité quantique ($C_q$) en série avec ladite capacité de grille ($C_g$) entraînant une capacité totale ($C_{tot}$) entre la structure de détection de charge (CE) et la structure d'électrode de grille (G, BE) ;

    - un circuit de lecture connecté électriquement à la structure de détection de charge (CE) ou à la structure d'électrode de grille (G), pour détecter une tension de sortie ($V_o$) qui est représentative desdites charges électriques détectées stockées dans ladite capacité totale ($C_{tot}$) et fournir un signal de lecture ($S_o$) sur la base de la tension de sortie ($V_o$) détectée ;

dans lequel ledit circuit de lecture comprend :

    - un amplificateur (A) avec une première entrée connectée électriquement à la structure de détection de charge (CE) ou à la structure d'électrode de grille (G), pour détecter ladite tension de sortie ($V_o$) et fournir, à une sortie de l'amplificateur (A), ledit signal de lecture ($S_o$) ; et
    - un condensateur de référence ($C_{ref}$) qui a une magnitude égale à ou différant au maximum de 50 % par rapport à ladite capacité totale ($C_{tot}$) lorsqu'il n'y a pas de charge électrique induite ou de densité de porteurs de charge électrique sur la structure de détection de charge (CE), dans lequel ledit condensateur de référence ($C_{ref}$) a une première plaque connectée électriquement à ladite première entrée de l'amplificateur (A) ;
    et **en ce que** l'appareil électronique comprend en outre une première borne d'entrée ($TV_g$) connectée électriquement à l'une de ladite structure d'électrode de grille (G) et de ladite structure de détection de charge (CE) qui n'est pas connectée électriquement à la première entrée de l'amplificateur (A) ;
    dans lequel la première borne d'entrée ($TV_g$) est accessible pour y appliquer une tension de commande ($V_g$) qui est sélectionnée de manière à ce que le niveau de Fermi de la structure de détection de charge (CE) soit réglé sur le point le plus sensible ;
    de sorte que lorsque ladite capacité totale ($C_{tot}$) change en raison d'une variation de la capacité quantique ($C_q$) causée par une charge électrique ou une densité de porteurs de charge électrique induite sur la structure de détection de charge (CE), un déséquilibre entre la capacité totale ($C_{tot}$) et la capacité de référence ($C_{ref}$) entraîne une variation de la tension de sortie ($V_o$) sur la première entrée de l'amplificateur (A) qui est amplifiée pour fournir le signal de lecture ($S_o$).

2. Système comprenant un appareil électronique, dans lequel l'appareil électronique est défini selon la revendication 1, et dans lequel ledit circuit de lecture comprend en outre des moyens configurés et agencés pour sélectionner et appliquer ladite tension de commande ($V_g$) à la une de ladite structure d'électrode de grille (G) et de ladite structure de détection de charge (CE) qui n'est pas connectée électriquement à la première entrée de l'amplificateur (A).

3. Système selon la revendication 2, dans lequel le circuit de lecture comprend en outre un premier mécanisme de correction du décalage comprenant lesdits moyens, qui sont configurés et agencés pour sélectionner et appliquer une première tension de référence ($V_{ref1}$) à une seconde plaque du condensateur de référence ($C_{ref}$), de sorte que la tension de sortie ($V_o$) sur la première entrée de l'amplificateur (A) est nulle lorsqu'il n'y a pas de charge électrique induite ou de densité de porteurs de charge électrique sur la structure de détection de charge (CE).

4. Système selon la revendication 2 ou 3, dans lequel ledit moyen comprend une source de tension qui génère ladite tension de commande ($V_g$).

5. Système selon la revendication 2, 3 ou 4, dans lequel ledit moyen comprend une unité de commande (CU) configurée et agencée pour sélectionner et appliquer ladite tension de commande ($V_g$).

6. Système selon la revendication 5, dans lequel l'unité de commande (CU) est configurée pour sélectionner les propriétés de ladite tension de commande ($V_g$), au moins en ce qui concerne sa magnitude.

7. Système selon l'une quelconque des revendications 2 à 6, dans lequel ledit circuit de lecture comprend en outre un second mécanisme de correction de décalage comprenant lesdits moyens qui sont configurés et agencés pour sélectionner et appliquer à une seconde entrée de l'amplificateur (A) une seconde tension de référence ($V_{ref2}$) avec une magnitude égale ou sensiblement égale à la tension de sortie ($V_o$) lorsque la structure de sensibilité à la charge (CE) est réglée sur son point de sensibilité le plus élevé et qu'il n'y a pas de charge électrique ou de densité de porteurs de charge électrique induite par la quantité physique externe.

8. Système selon la revendication 7 lorsqu'il dépend de la revendication 5, dans lequel ladite unité de commande (CU) est également configurée et agencée pour sélectionner et appliquer ladite seconde tension de référence ($V_{ref2}$).

9. Système selon l'une quelconque des revendications 2 à 8, dans lequel le circuit de lecture comprend en outre un circuit de réinitialisation pour décharger la capacité totale (Ctot).

10. Système selon l'une quelconque des revendications 2 à 9, dans lequel le dispositif électronique comprend en outre une structure de sensibilisation (PS) ou de fonctionnalisation (PS) agencée sur ladite structure de détection de charge (CE), dans lequel ladite structure de sensibilisation (PS) ou structure de fonctionnalisation (PS) est configurée pour induire lesdites charges électriques et/ou modifier la densité de porteurs de charge électrique induite dans celle-ci par ladite quantité physique externe, dans lequel la structure de sensibilisation (PS) ou structure de fonctionnalisation (PS) n'est sensible qu'à ladite quantité physique externe.

11. Système selon l'une quelconque des revendications 2 à 10, dans lequel ledit condensateur de référence ($C_{ref}$) est un composant séparé, par rapport au dispositif électronique.

12. Système selon la revendication 10, dans lequel ledit condensateur de référence ($C_{ref}$) est mis en oeuvre par le dispositif électronique, avec ladite première plaque constituée par ladite structure de détection de charge (CE), une structure diélectrique constituée par ladite structure de sensibilisation (PS) ou ladite structure de fonctionnalisation (PS), et ladite seconde plaque constituée par une structure d'électrode supérieure (TE) agencée sur ladite structure de sensibilisation (PS) ou ladite structure de fonctionnalisation (PS).

13. Système selon l'une quelconque des revendications 2 à 12, dans lequel le dispositif électronique et au moins une partie du circuit de lecture sont mis en oeuvre par CMOS.

14. Système selon la revendication 10 ou 12, dans lequel ladite structure de sensibilisation (PS) ou ladite structure de fonctionnalisation (PS) est une structure photoactive configurée et agencée pour, lors de l'illumination, générer des paires électron-trou qui, en raison d'un champ créé par une jonction Schottky entre la structure de détection de charge (CE) et la structure photoactive (PS) ou une structure d'électrode supérieure (TE) au sommet de la structure photoactive (PS), sont séparées et les électrons ou les trous sont transportés, en tant que porteurs de charge électrique induits, vers la structure de détection de charge (CE).

15. Système selon la revendication 14, mettant en oeuvre un capteur d'image comprenant un réseau de pixels, dans lequel l'appareil électronique comprend une pluralité desdits dispositifs électroniques constituant chacun un pixel dudit réseau de pixels.

**Fig. 1**

**Fig. 2**

EP 3 691 253 B1

Fig. 3

**Fig. 4**

PS

CE

D

BE

S

## Fig. 5

PS

CE

D

BE

S

## Fig. 6

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 3429190 A1
- US 10070082 B2
- US 2017082566 A1
- US 2014111652 A
- US 2018197956 A

**Non-patent literature cited in the description**

- **M. A. EBRISH et al.** Dielectric thickness dependence of quantum capacitance in graphene varactors with local metal back gates. *70th Device Research Conference,* 18 June 2021
- **GERASIMOS KONSTANTATOS et al.** Hybrid graphene-quantum dot phototransistors with ultra-high gain. *Nature Nanotechnology,* 2012, vol. 7, 363-368
- Topical Review; Graphene field-effect transistors; Topical review. **DHARMENDAR REDDY et al.** Journal of Physics D: Applied Physics. Institute of Physics Publishing LTD, 14 July 2011, vol. 44, 313001
- **FOXE M et al.** Detection of ionizing radiation using graphene field effect transistors. *2009 IEEE Nuclear Science Symposium and Medical Imaging Conference (NSS/MIC 2009),* 24 October 2009, 90-95